Europäisches Patentamt

**European Patent Office**

**Office européen des brevets**

(11) Veröffentlichungsnummer: **0 062 205**
A2

(12) # EUROPÄISCHE PATENTANMELDUNG

(21) Anmeldenummer: **82102317.3**

(22) Anmeldetag: **20.03.82**

(51) Int. Cl.³: **G 01 G 3/12,** G 01 G 3/147,
G 01 R 17/02, G 01 R 17/06

(30) Priorität: **07.04.81 US 247525**

(43) Veröffentlichungstag der Anmeldung: **13.10.82**
**Patentblatt 82/41**

(84) Benannte Vertragsstaaten: **AT BE CH DE FR GB IT LI NL SE**

(71) Anmelder: **Bizerba-Werke Wilhelm Kraut GmbH & Co. KG., Wilhelm-Kraut-Strasse 41, D-7460 Balingen 1 (DE)**

(72) Erfinder: **Sarkison, Warren, 5811 Padua Drive, Huntington Beach California 92649 (US)**

(74) Vertreter: **Hoeger, Stellrecht & Partner, Uhlandstrasse 14c, D-7000 Stuttgart 1 (DE)**

(54) **Elektronische Wägevorrichtung.**

(57) Eine elektronische Wägevorrichtung umfaßt einen elektromechanischen Wandler (10), der ein erstes analoges Ausgangssignal (11) liefert, sowie einen Digital-Analog-Wandler (14), der ein zweites Ausgangssignal (15) erzeugt. Ein erster Differenzverstärker (20) empfängt diese Ausgangssignale und liefert ein drittes Ausgangssignal (23). Ein zweiter Differenzverstärker (22) erhält das dritte Ausgangssignal (21) und ein Ausgangssignal des Wandlers (14), um hieraus ein weiteres Ausgangssignal (26) zu erzeugen. Ein größerer Teil des Gewichts des gewogenen Gegenstandes wird am Ausgang des ersten Differenzverstärkers (20) in einer Grobmessung bestimmt. Der Restteil oder die Differenz wird anschließend verstärkt und am zweiten Differenzverstärker (22) ausgeglichen. Hierdurch ist eine genaue Gewichtsbestimmung und ein Betreiben des Digital-Analog-Wandlers im Rückkopplungsbetrieb ermöglicht.

- 1 -

Beschreibung:

Elektronische Wägevorrichtung

Die Erfindung betrifft eine elektronische Wägevorrichtung.

Allgemein hat es die Erfindung mit dem Betrieb elektronischer Waagen zu tun. Insbesondere bezieht sie
sich auf die Vereinfachung des elektrischen Schaltkreises einer Waage und die Fehlerreduzierung bei
der Ablesung solcher Waagen.

In bekannten elektronischen Waagen werden elektromagnetische (Kraft-) Wandler dazu ausgenutzt, um
Spannungen oder Signale zu erzeugen, die dem Gewicht von auf die Waage aufgebrachten Gegenständen
proportional sind. Derartige Spannungen oder Signale
werden anschließend verstärkt und durch Messung der
Spannungen oder Signale zur Anzeige gebracht. Bei
diesem Vorgehen werden häufig Fehler induziert, die
beispielsweise auf den Betrieb der Meßvorrichtungen
und Temperaturveränderungen zurückgehen können.

- 2 -

Es ist Aufgabe der Erfindung, eine Schaltanordnung vorzuschlagen, durch welche die Nachteile bekannter elektronischer Waagenschaltkreise überwunden werden und die dem Ausgangssignal einer elektronischen Waage einen sehr hohen Genauigkeitsgrad verleihen.

Die Aufgabe wird erfindungsgemäß durch folgende Merkmale gelöst:

a. einen elektromechanischen (Kraft-) Wandler zur Erzeugung eines ersten, analogen Ausgangssignals;

b. einen Digital-Analog-Wandler zur Erzeugung eines zweiten Ausgangssignals;

c. einen ersten, mit den vorgenannten Wandlern verbundenen Differenzverstärker, dem als Eingangssignale Signale zugeleitet sind, die den ersten und zweiten Ausgangssignalen entsprechen, und der ein drittes Ausgangssignal liefert, das seinerseits der verstärkten Differenz zwischen den ersten und zweiten Ausgangssignalen entspricht, und

d. einen mit dem Ausgang des ersten Verstärkers sowie mit dem Ausgang des Digital-Analog-Wandlers verbundenen, zweiten Differenzverstärker, dem als Eingangssignale Signale zugeleitet sind, die dem dritten Ausgangssignal und einem vierten

- 3 -

Ausgangssignal des eben genannten Wandlers entsprechen, und der ein fünftes Ausgangssignal
liefert, das seinerseits der Differenz zwischen
den dritten und vierten Ausgangssignalen entspricht.

Als Folge hiervon wird ein größerer Anteil des Gewichts des gewogenen Gegenstands am Ausgang des
ersten Differenzverstärkers bestimmt (d. h. es
erfolgt eine Grobmessung). Der verbleibende Teil
oder die Differenz wird anschließend verstärkt und
am zweiten Differenzverstärker ausgeglichen, so daß
eine genaue Gewichtsbestimmung und ein Betreiben des
Digital-Analog-Wandlers im Rückkopplungsbetrieb
möglich ist. Vorzugsweise ist eine Filter/Verstärker-
Anordnung in Reihe zwischen den beiden Differenzverstärkern vorgesehen. Die Spannung am Ausgangspunkt eines Filterverstärkers wird vorteilhafterweise
zum Betreiben der Anzeige der Waage ausgenutzt.

Die nachstehende Beschreibung einer bevorzugten
Ausführungsform der Erfindung dient im Zusammenhang
mit der Zeichnung der weiteren Erläuterung. Es zeigt:

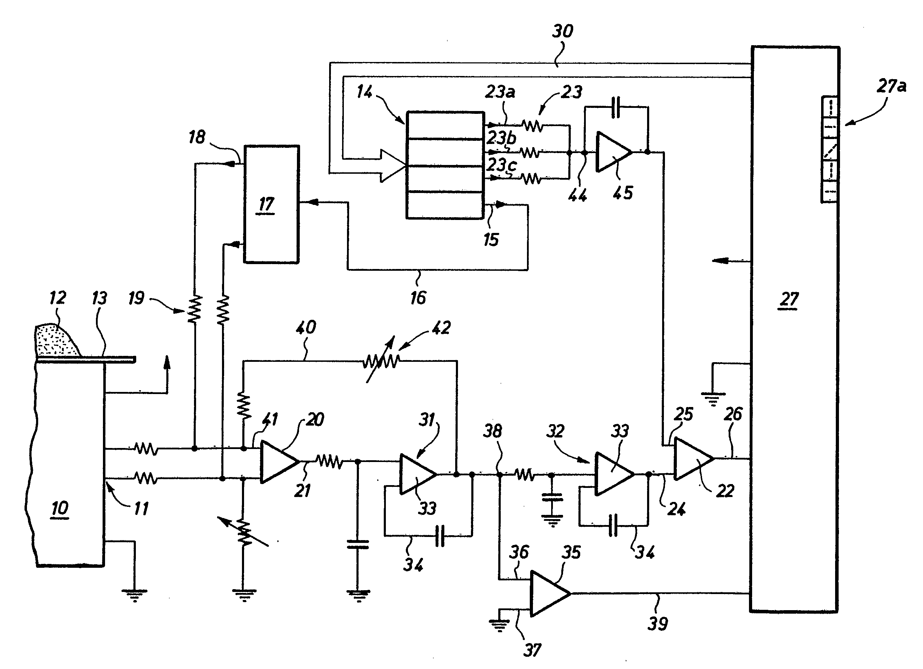

Fig. 1    ein Schaltdiagramm.

- 4 -

In Fig. 1 bedeutet der Block 1o eine Wägezelle oder
einen elektromechanischen (Kraft-) Wandler, dessen
bei dem Bezugszeichen 11 erscheinendes, analoges
Ausgangssignal direkt proportional zu dem Gewicht
oder der Masse eines Körpers 12 auf einer Wägeplatte
13, die ihrerseits auf die Wägezelle einwirkt. Ein
Digital-Analog-Wandler 14 liefert ein zweites, analoges Ausgangssignal (Bezugszeichen 15), welches
durch Vermittlung einer Leitung 16 einen Treiber 17
zugeleitet ist. Die Ausgangssignale 18 des Treibers,
die den Ausgangssignalen 15 des Wandlers 14 entsprechen, werden bei 19 einem ersten Differenzverstärker 2o zugeleitet, der weiterhin auch als Eingangssignal das Ausgangssignal 11 aus der Wägezelle
empfängt. Der als Komparator arbeitende Verstärker
2o liefert ein drittes analoges Ausgangssignal 21,
welches der verstärkten Differenz zwischen den Ausgangssignalen 11 und 15 entspricht.

Ein zweiter Differenzverstärker (oder Komparator) 22
ist mit der Ausgangsseite des ersten Differenzverstärkers 2o sowie mit dem Ausgang des Digital-
Analog-Wandlers 14 verbunden, so daß er als Eingangssignale bei 24 und 25 Signale erhält, die dem dritten
Ausgangssignal 21 bzw. einem vierten Ausgangssignal
23 des Wandlers 14 entsprechen. Auf diese Weise
liefert der Verstärker 22 ein fünftes Ausgangssignal
26, welches der Differenz zwischen den erwähnten dritten und vierten Ausgangssignalen 21 bzw. 23 entspricht. Das Ausgangssignal 26 wird zu einem Steuerschaltkreis 27 übertragen. Der letztere enthält
einen Mikroprozessor, der vom Ausgangssignal 26
getrieben wird und bei der bevorzugten Ausführungsform einen Analog-Digital-Wandler mit digitaler
Ableseanzeige 27a umfaßt, wobei die letztere das
Gewicht des Gegenstandes 12 auf der Waage anzeigt.
Das digitale Ausgangssignal des Mikroprozessors wird
bei 3o auch zum Digital-Analog-Wandler 14 geleitet,
um diesen nach Vorzeichen und Betrag anzutreiben
derart, daß die Ausgangssignale 15 und 23 des Wandlers 14, wenn sie den Differenzverstärkern 2o und 22
zugeführt werden, rasch ein Nenn- oder Null-Ausgangssignal 26 erzeugen. In dieser Hinsicht ist die Größe
des Ausgangssignals 15 bei der bevorzugten Ausführungsform der Erfindung wesentlich größer (beispielsweise vierundsechzig mal größer) als der Pegel des
Ausgangssignals 23. Das Signal 15 wird mit dem Ausgangssignal 23 digital aufsummiert, um bei dem
richtigen Gewicht anzulangen.

Als weiteres Schaltmittel sind Filtermittel vorgesehen, beispielsweise erste und zweite Filterverstärker 31 und 32, die, wie dargestellt, zwischen
den ersten und zweiten Differenzverstärkern in Reihe
geschaltet sind. Diese Filterverstärker entfernen
Welligkeiten und Störspannungen in dem im wesentlichen als Gleichstromsignal vorliegenden Ausgangs-

signal des Verstärkers 2o. Weiterhin verstärken sie
den Fehler oder das Differenzausgangssignal bei 21.
Jedes Filter enthält einen Verstärker 33 mit Rückkopplung 34. Somit wird der Fehler bei 21 durch erneute Verstärkung im Verstärker 22 genau ausgeglichen.

Ein weiterer Komparator 35 besitzt Ausgangsklemmen
36 und 37, die mit einem Punkt 38 bzw. Erde verbunden sind. Der Ausgang 39 des Schaltgliedes 35 ist
mit dem Steuerschaltkreis 27 verbunden, um auf diese
Weise einen raschen Antrieb der Anzeige 27a in Übereinstimmung mit der Spannung bei 38 zwischen den
beiden Filtern zu vermitteln. Eine Rückkopplungsschleife 4o liegt zwischen Punkt 38 und dem Eingangspunkt 41 des ersten Differenzverstärkers 2o. Dies
dient über einen einstellbaren Widerstand 42 der
Einstellung der Verstärkung des Verstärkers 2o und
dem Auf-Null-Bringen der Anzeige.

Wie dargestellt, wird der Ausgang 23 des Digital-
Analog-Wandlers 14 von drei Ausgangssignalen 23a,
23b, 23c gebildet. Diese Ausgangssignale verlaufen
zueinander parallel und werden bei 44 am Eingang
eines Summier- und Filterverstärkers 45 aufsummiert.

In der nachstehenden Liste sind die im Handel verfügbaren Schaltelemente der beschriebenen Schaltung
aufgeführt:

<u>Bezeichnung und Hersteller</u>

| | | |
|---|---|---|
| Wägezelle | MK VI | Load Cells Inc. |
| Wandler | UA 9706 | Fairchild |
| Treiber | 4o-13 | Fairchild |
| Verstärker | PO-o7 | Fairchild |
| Verstärker | LM 311 | National Semiconductor |
| Mikroprozessor | 8o8o | Intel |

0062205

- 8 -

Patentansprüche :

1. Elektronische Wägevorrichtung, gekennzeichnet
durch folgende Merkmale:

a. einen elektromechanischen (Kraft-) Wandler (1o)
zur Erzeugung eines ersten analogen Ausgangssignals (11);

b. einen Digital-Analog-Wandler (14) zur Erzeugung eines zweiten Ausgangssignals (15);

c. einen ersten, mit den Wandlern (1o und 14)
verbundenen Differenzverstärker (2o), dem als
Eingangssignale Signale zugeleitet sind, die
den ersten und zweiten Ausgangssignalen (11,
15) entsprechen, und der ein drittes Ausgangssignal (21) liefert, das seinerseits der verstärkten Differenz zwischen den ersten und
zweiten Ausgangssignalen entspricht, und

d. einen mit dem Ausgang des ersten Verstärkers
(2o) sowie mit dem Ausgang des Digital-Analog-
Wandlers (14) verbundenen, zweiten Differenzverstärker (22), dem als Eingangssignale
Signale zugeleitet sind, die dem dritten Ausgangssignal (21) und einem vierten Ausgangssignal (23) des Wandlers (14) entsprechen,
und der ein fünftes Ausgangssignal (26) liefert,
das seinerseits der Differenz zwischen den
dritten und vierten Ausgangssignalen entspricht.

2. Vorrichtung nach Anspruch 1, dadurch gekennzeichnet, daß Filtermittel (31,32) zwischen den ersten
und zweiten Differenzverstärkern (2o,22) in Reihe
geschaltet sind.

3. Vorrichtung nach Anspruch 2, dadurch gekennzeichnet, daß die Filtermittel erste und zweite, in
Reihe geschaltete Filter (33) umfassen und eine
Ausgangsklemme einschließen, die mit dem Ausgang
des ersten Filters (33) verbunden ist.

4. Vorrichtung nach Anspruch 1, 2 oder 3, dadurch
gekennzeichnet, daß zwischen dem Digital-Analog-
Wandler (14) und dem ersten Differenzverstärker
(2o) ein Differenztreiber (17) eingeschaltet ist.

5. Vorrichtung nach einem der Ansprüche 1 bis 4,
dadurch gekennzeichnet, daß mit dem Wandler (14)
eine Steuereinrichtung (27) verbunden ist, die
der Einstellung des Pegels des zweiten Ausgangssignals (15) dient.

6. Vorrichtung nach Anspruch 5, dadurch gekennzeichnet, daß der Wandler (14) einen Schaltkreis zur Einstellung des aus dem Wandler austretenden, zweiten Ausgangssignals bei einem Pegel einschließt, der ein Vielfaches desjenigen des vierten Ausgangssignals (23) des Wandlers (14) ist.

7. Vorrichtung nach einem der voranstehenden Ansprüche, dadurch gekennzeichnet, daß zwischen den zweiten Differenzverstärker (22) und den Wandler (14) ein Mikroprozessor eingeschaltet ist, der den Wandler so treibt, daß das fünfte Ausgangssignal (26) minimal gehalten ist.

8. Vorrichtung nach einem der voranstehenden Ansprüche, dadurch gekennzeichnet, daß zwischen der Ausgangsseite des ersten Filters (33) und dem Mikroprozessor Schaltmittel eingeschaltet sind, um den letzteren zu treiben.

1/1

0062205